# EUROPEAN PATENT APPLICATION

(11) **EP 3 333 890 A1**
(43) Date of publication of application: **13.06.2018**
(21) Application number: 17205324.1
(22) Date of filing: 05.12.2017
(51) Int. Cl.: H01L 23/40

(54) **RETAINING CLIP FOR ELECTRONIC DEVICE**

(30) Priority: 06.12.2016 US 201662430413 P
(71) Applicant: THOMSON LICENSING, 92130 Issy les Moulineaux (FR)
(72) Inventor: RITTER, Darin, Indianapolis, IN 46290 (US); CRAIG, Randy, Indianapolis, IN 46290 (US); DERNIER, William, Indianapolis, IN 46290 (US)
(74) Representative: Huchet, Anne

(57) **Abstract**

An electronic device having a retaining clip adapted to be applied to secure and/or compress e.g., a heat sink element to the rest of the assemblies of the electronic device is provided. The retaining clip has a first planar region having a first end (e.g., a top end), and a second end, e.g., opposite or distal to the first end (e.g., a bottom end); a second planar region on the second end of the first planar region; a third planar region on the first end of the first planar region; a V-shape bend on an end of the third planar region; and an L-shape bend on an end of the second planar region.

## Description

### TECHNICAL FIELD

The present principles generally relate to thermal mitigation in electronic devices and particularly to a retaining clip adapted to be applied to secure and/or compress e.g., a heat sink element to dissipate heat in an electronic device. Also provided is an exemplary electronic device comprising such a retaining clip.

### BACKGROUND

This section is intended to introduce to the reader various aspects of background information which may be related to various aspects of the present principles that are described and/or claimed below. This discussion is believed to be helpful in providing the reader with background information to facilitate a better understanding of the various aspects of the present principles. Accordingly, it should be understood that these statements are to be read in this light, and not as admissions of prior art.

Heat sinks for electronic device are well known in the art. They are typically attached to electronic components (e.g., integrated circuits) of the electronic devices in order to dissipate the heat which the components generate during operation. In order to do this, the heat sinks are designed to have a maximum planar region surface and the size of which determines their heat dissipating capacity. For example, most heat sinks have a plurality of radiating fins on one or more of their planar regions in order to radiate and dissipate the heat. Also, most of the heat sinks are attached to a semiconductor package by e.g., a thermal adhesive/putty/paste layer applied to a backing plate of the heat sinks. In addition, some of the heat sinks are also secured to the components of the electronic devices by one or more of securing means, such as, e.g., a clamp or the like.

### SUMMARY

The present principles recognize that positional control of various elements of an electronic device such as e.g., thermal heat spreaders, heatsinks, thermal interface material, printed circuit boards, various shields, and etc., is critical to insure the stability of the designs and proper operation of the electronic device. Parts and/or components in an electronic device will have dimensional variations due to manufacturing processes and these variations if not controlled properly could result in incomplete thermal coupling at critical joints which would lead to potential device failure.

Accordingly, the present principles recognize that it is advantageous to be able to provide a retaining clip which is adapted to be applied to compress and/or secure an assembly of heat spreaders, heatsinks, thermal interface materials, PCBs and shields against key locating features of an electronic device. The exemplary retaining clip may be easily applied during the manufacturing process of the electronic device and would properly overcome one or more dimensional variations and distortions of the individual part and component to insure the proper dimensional control of the critical thermal coupling joints. Therefore, radiated heat generated by the various components of the electronic device may be appropriately dissipated.

Accordingly, a retaining clip is provided, comprising: a first planar region having a first end and a second end; a second planar region on the second end of the first planar region; a third planar region on the first end of the first planar region; a V-shape bend on an end of the third planar region; and an L-shape bend on an end of the second planar region.

In another exemplary embodiment according to the present principles, an electronic apparatus is provided, comprising: a heat sink assembly having a heat spreader planar region comprising a first mounting slot; a printed circuit board below the heat sink assembly; a component mounted on the printed circuit board; a metal shield covering the component; a metal frame below the printed circuit board having a second mounting slot; a retaining clip having a V-shape bend on one end and an L-shape bend on the other end; and wherein the L-shape bend is inserted into the second mounting slot and the V-shape bend is inserted into the first mounting slot.

In accordance with an aspect of the present disclosure, an embodiment comprises a retaining clip for use in an electronic device including: a first planar region having a first end and a second end; a second planar region on the second end of the first planar region; a third planar region on the first end of the first planar region; a V-shape bend on an end of the third planar region; and an L-shape bend on an end of the second planar region.

In accordance with another aspect, an embodiment comprising a retaining clip includes a V-shape bend comprising a fourth planar region which is perpendicular to the third planar region and a fifth planar region which is in an angle to the fourth planar region.

In accordance with another aspect, an embodiment comprising a retaining clip includes a fifth planar region which is in an angle to the fourth planar region wherein the angle is an acute angle.

In accordance with another aspect, an embodiment comprising a retaining clip includes an upwardly extending planar region.

In accordance with another aspect, an embodiment comprising a retaining clip having a V-shape bend includes an upwardly extending planar region being configured for manipulating the V-shape bend into a first mounting slot of a heat spreader planar region of a heat sink assembly of an electronic device.

In accordance with another aspect, an embodiment comprising a retaining clip includes an L-shape bend being configured for being inserted into a second mounting slot of a metal frame of the electronic device.

In accordance with another aspect, an embodiment comprising a retaining clip includes a first planar region, a second planar region and a third planar region wherein the second and third planar regions are parallel to each other and are perpendicular to the first planar region.

In accordance with another aspect, an embodiment comprising a retaining clip includes
the retaining clip being made from a single piece of material.

In accordance with another aspect, an embodiment comprising a retaining clip includes the material from which the retaining clip is made comprising stainless steel.

In accordance with another aspect, an embodiment comprising a retaining clip includes
the material from which the retaining clip is made being elastic to provide a springing action to compress a heat sink assembly.

In accordance with another aspect, an embodiment comprising a retaining clip having second and third planar regions includes the third planar region having a length which is longer than a length of the second planar region.

In accordance with another aspect, an embodiment comprises a retaining clip for use in an electronic device wherein the electronic device includes a heat sink assembly having a heat spreader planar region comprising a first mounting slot; a printed circuit board below the heat sink assembly; a component mounted on the printed circuit board; a metal shield covering the component; and a metal frame below the printed circuit board having a second mounting slot; wherein the retaining clip has a V-shape bend on one end and an L-shape bend on the other end; and wherein the L-shape bend is inserted into the second mounting slot and the V-shape bend is inserted into the first mounting slot.

In accordance with another aspect, an embodiment comprises a retaining clip for use in an electronic device wherein the electronic device includes a heat sink assembly having a heat spreader planar region; and a first standoff below the heat spreader planar region of the heat sink assembly.

In accordance with another aspect, an embodiment comprises a retaining clip for use in an electronic device wherein the electronic device includes a heat sink assembly having a heat spreader planar region; a first standoff below the heat spreader planar region of the heat sink assembly; a printed circuit board below the heat sink assembly; and a second standoff below the printed circuit board.

### BRIEF DESCRIPTION OF THE DRAWING

The above-mentioned and other features and advantages of the present principles, and the manner of attaining them, will become more apparent and the present principles will be better understood by reference to the following description of embodiments of the present principles taken in conjunction with the accompanying drawings, wherein:
Fig. 1A shows a side view of an exemplary apparatus according to the present principles;
Fig. 1B to 1D show the different perspective views of the exemplary apparatus shown in Fig. 1A.
Fig. 2 shows another perspective view of the exemplary apparatus shown in Fig. 1A in a partially assembled state; and
Fig. 3 also shows another perspective view of the exemplary apparatus shown in Fig. 1A in a partially assembled state.

The examples set out herein illustrate exemplary embodiments of the present principles. Such examples are not to be construed as limiting the scope of the present principles in any manner.

### DETAILED DESCRIPTION

The present description illustrates the present principles. It will thus be appreciated that those skilled in the art will be able to devise various arrangements that, although not explicitly described or shown herein, embody the present principles and are included within its scope.

All examples and conditional language recited herein are intended for aiding the reader in understanding the present principles and the concepts contributed by the inventors to furthering the art, and are to be construed as being without limitation to such specifically recited examples and conditions.

Moreover, all statements herein reciting principles, aspects, and embodiments of the present principles, as well as specific examples thereof, are intended to encompass both structural and functional equivalents thereof. Additionally, it is intended that such equivalents include both currently known equivalents as well as equivalents developed in the future, i.e., any elements developed that perform the same function, regardless of structure.

Reference in the specification to "one embodiment", "an embodiment", "an exemplary embodiment" of the present principles, or as well as other variations thereof, means that a particular feature, structure, characteristic, and so forth described in connection with the embodiment is included in at least one embodiment of the present principles. Thus, the appearances of the phrase "in one embodiment", "in an embodiment", "in an exemplary embodiment", or as well any other variations, appearing in various places throughout the specification are not necessarily all referring to the same embodiment.

It is to be appreciated that the use of any of the following "/", "and/or", and "at least one of", for example, in the cases of "A/B", "A and/or B" and "at least one of A and B", is intended to encompass the selection of the first listed option (A) only, or the selection of the second listed option (B) only, or the selection of both options (A and B). As a further example, in the cases of "A, B, and/or C" and "at least one of A, B, and C", such phrasing is intended to encompass the selection of the first listed option (A) only, or the selection of the second listed option (B) only, or the selection of the third listed option (C) only, or the selection of the first and the second listed options (A and B) only, or the selection of the first and third listed options (A and C) only, or the selection of the second and third listed options (B and C) only, or the selection of all three options (A and B and C). This may be extended, as readily apparent by one of ordinary skill in this and related arts, for as many items listed.

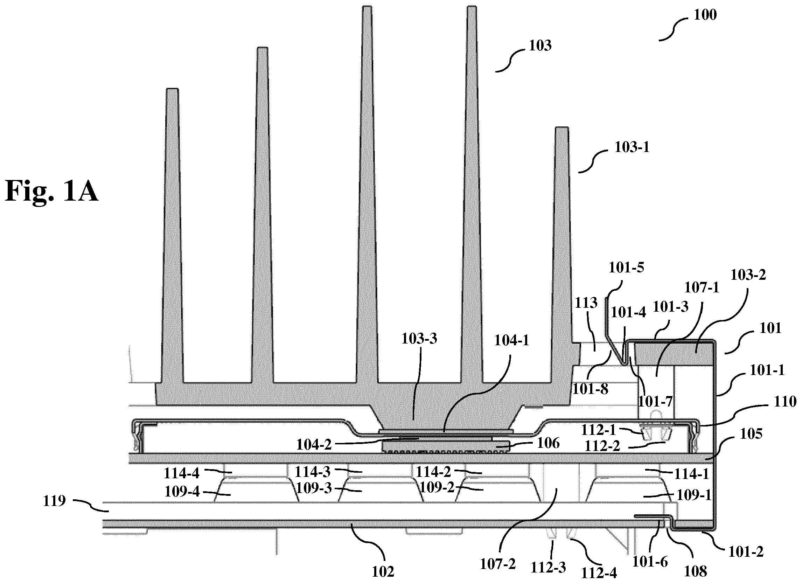

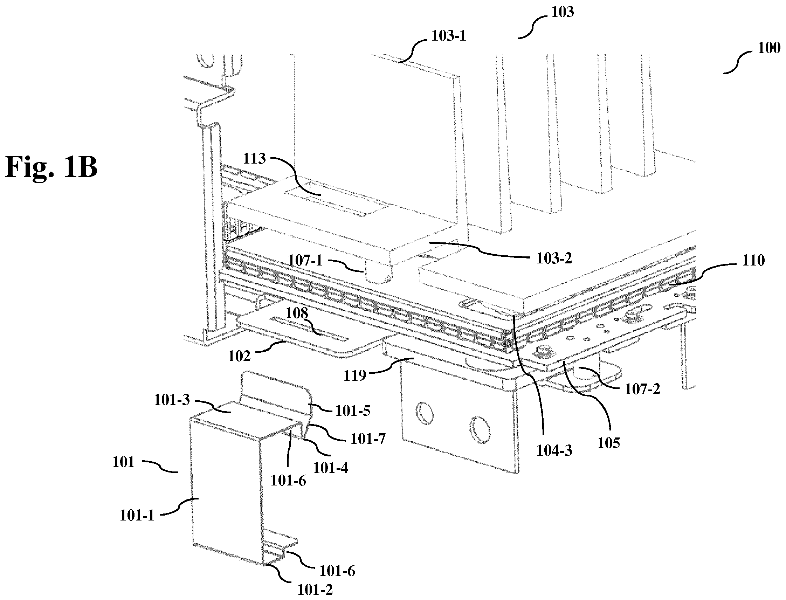

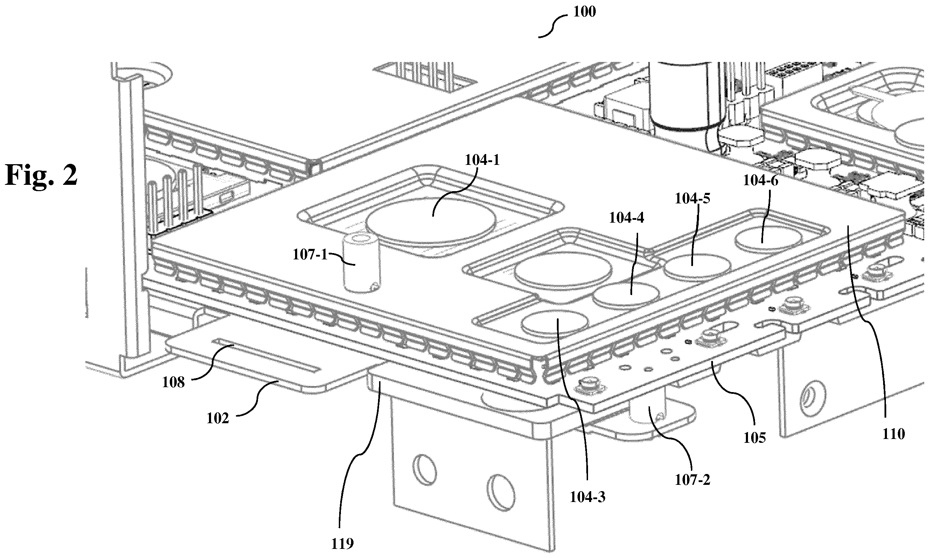

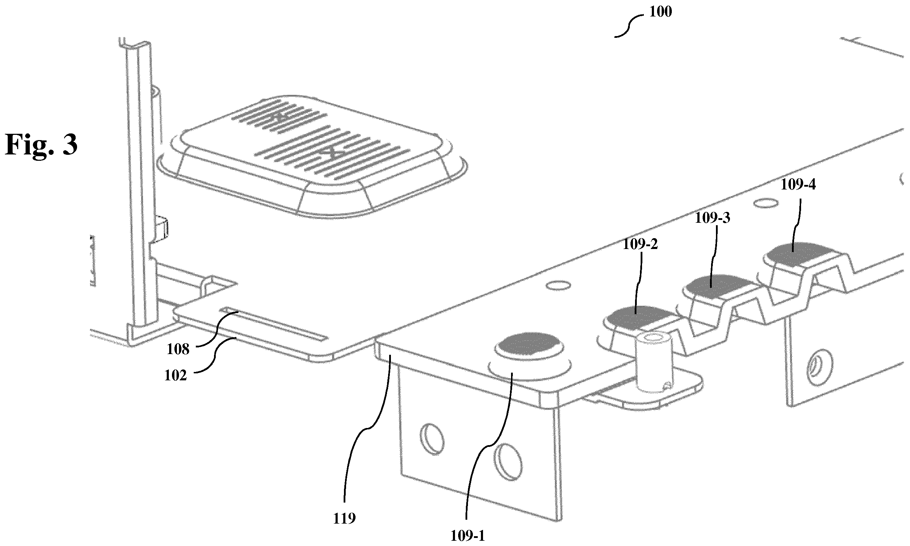

Fig. 1A shows a side view of a relevant portion of an exemplary electronic device 100 comprising an exemplary retaining clip 101 according to the present principles. Figs. 1B to 1D show the different perspective views at different angles of the same exemplary electronic device 100. Fig. 2 and Fig. 3 show respectively additional perspective views of the same exemplary electronic device 100 in a partially assembled state according to the present principles. Since all of the figures mentioned above illustrate the same exemplary electronic device 100 comprising the same exemplary retaining clip 101, the same numbering is used to label the same element in each of the above-mentioned figures, Figs. 1A-1D and Figs 2 and 3, of the drawings.

The exemplary electronic device 100 shown in the figures may be, for example, included in or a portion of a device such as a home media server model HS17 from Technicolor, Inc. The Technicolor home media server model HS17 is a high-end home media server that provides media content from a satellite broadcast system to home client devices over a variety of home network formats (e.g., wired and wireless) in a uniquely aesthetic industrial design package. As shown in e.g., Fig. 1A and Fig. 1B, according the present principles, an exemplary retaining clip 101 is provided to compress and/or secure together a plurality of parts and/or layers of the electronic device 100 as to be described in further detail below. In an exemplary embodiment according to the present principles, a heatsink assembly 103 shown in e.g., Fig. 1A and Fig. 1B, is compressed and/or secured via the exemplary retaining clip 101 to the rest of the assemblies of the electronic device 100. The heatsink assembly 103 may comprise one or more heat dissipating fins such as e.g., fin 103-1, and one or more metal heat spreader planar regions such as, e.g., 103-2, as shown in e.g., Fig. 1A and Fig. 1B.

The exemplary retaining clip 101 may be made using a single piece of material (i.e., in a "single-body" or "uni-body" construction). The material of the retaining clip 101 may be, e.g., stainless steel. In other non-limiting exemplary embodiments, the retaining clip 101 may be made from other types of metal such as, e.g., aluminum, or even non-metal material such as e.g., thermal plastic. In one exemplary embodiment, the material is elastic in order to provide a springing action of the clip for compressing and fastening the clip to a heat sink assembly 103, and/or the rest of the assemblies of the electronic device 100, as shown in e.g., Fig. 1A and Fig. 1B.

In accordance with the present principles, descriptions herein of exemplary embodiments of a retaining clip incorporating the present principles may refer to "one end" and second end", e.g., of a retaining clip or portions of a retaining clip. However, depending on the orientation of an electronic device and, correspondingly, the orientation of the retaining clip when installed in an electronic device, references to a "side" or "end" of a retaining clip or portions of a retaining clip as described herein are intended to encompass various embodiments and configurations and, depending on the orientation, may be appropriately and, in a non-limiting manner, referred to as "first end" and "second end", or "top end" and "bottom end", or "one end" and "other end", or "one end" and "opposite end", or "left end" and "right end", or "one side" and "opposite side", etc. That is, as will be apparent to one skilled in the art, the present principles are applicable to and are intended to encompass various embodiments independent of orientation of an embodiment or an electronic device including an embodiment. For ease of explanation, the description herein may refer to "top" and "bottom" in accordance with the exemplary embodiment shown in Figures 1A and 1B. Such references are exemplary and non-limiting.

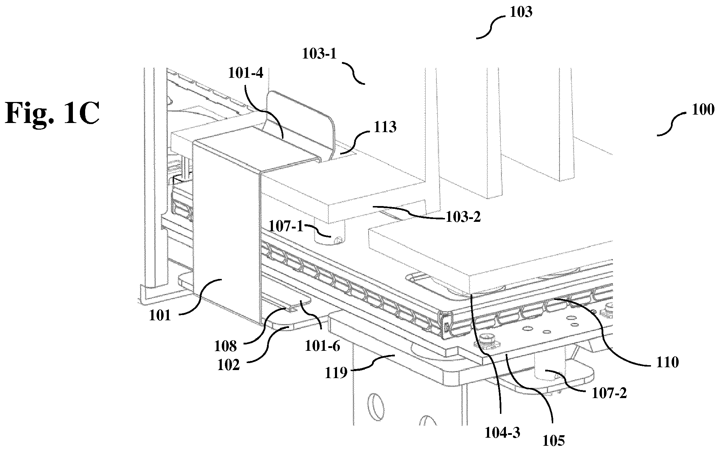

According to the present principles as shown in, e.g., Fig. 1A and Fig. 1B, the exemplary thermal retaining clip 101 has a first planar region 101-1 having a first end and a second end corresponding, for example, to a "top end" and "bottom end", respectively, or "one end" and "opposite end", respectively, in an exemplary embodiment oriented as in Figures 1A and 1B. There are additionally two planar regions, one on each end of the first planar region 101-1: a second planar region 101-2 on the second or bottom end of the first planar region 101-1, and a third planar region 101-3 on the first or top end of the first planar region 101-1. These two planar regions 101-2 and 101-3 may both be substantially perpendicular to the first planar region 101-1 and may be substantially parallel to each other. The third or top planar region 101-3 has a length (e.g., horizontal length) which may be longer than a length (e.g., horizontal length) of the second or bottom planar region 101-2. At the one end of the top planar region 101-3 (e.g., at an end distal to the first planar region or an opposite end to the top end of the first planar region 101-1), there is a V-shape, angular bend 101-4. The bend 101-4 may be used for being inserted into a first or top mounting slot 113 on one of the heat spreader planar regions 103-2 of the heat sink assembly 103, as shown in, e.g., Fig. 1A and Fig. 1B. Accordingly, Fig. 1C illustrates when the bend 101-4 of the exemplary clip 101 has been inserted into the top mounting slot 113 on one of the heat spreader planar regions 103-2 of a heat sink assembly 103, and that the clip 101 is securely fastened to the rest of the assemblies of the electronic device 100.

Also, as shown in e.g., Fig. 1A and Fig. 1B, in one exemplary embodiment according to the present principles, the V-shape bend 101-4 comprises one planar region, e.g., a fourth planar region, 101-7 extending downward from the one end of the top planar region 101-3 of the retaining clip 101 and is also substantially perpendicular to the top planar region 101-3 of the clip 101. The V-shape bend 101-4 also comprises another planar region, e.g., a fifth planar region, 101-8 which is in an acute angle to the planar region 101-7. In another exemplary embodiment, another or sixth planar region 101-5 which may be parallel to the first planar region 101-1, extends upwardly from the end of the angled planar region 101-7 of the bend 101-4. One exemplary usage of the extended planar region 101-5 is for the ease of manipulating the V-shape bend 101-4 into the upper mounting slot 113 as shown in Fig. 1C.

Also, as shown in e.g., Fig. 1A and Fig. 1B, at one end of the second or bottom planar region 101-2 of the exemplary retaining clip 101 (e.g., at an end of the second planar region that is distal from or at an opposite end of the second or bottom end of the first planar region 101-1), there is another bend 101-6. The bottom bend 101-6 of the retaining clip 101 is substantially in an L-shape. The long end of the L-shape bend 101-6 is used for being inserted into a second or bottom mounting slot 108 of a metal frame 102 of the electronic device 100. Fig. 1C also illustrates when the bottom bend 101-6 of the exemplary clip 101 has been inserted into the bottom mounting slot 108 on the metal frames 102 of the electronic device 100, and that the clip 101 is securely fastened to the rest of the assemblies of the electronic device 100.

According the present principles, one or more exemplary electronic components 106 may be mounted on a printed circuit board 105 as shown in, e.g., Fig. 1A. The one or more electronic components may be, e.g., a System on the Chip (SOC) integrated circuit (IC), a Tuner IC and/or a WIFI controlling IC, and etc., of the electronic device 100. In addition, an exemplary metal shield 110 may be used to provide, e.g., electromagnetic shielding protection for the one or more electronic components 106 as shown in Fig. 1A. Also, an exemplary thermal putty layer 104-1 may be provided between a backing planar region 103-3 of the heat sink 103 and the metal shield 110. Another exemplary thermal putty region may also be provided between the metal shield 110 and the top of the components 106 in order to better provide appropriate thermal conduction and radiation for the components 106.

According to another aspect of the present principles, as shown in, e.g., Fig. 1A, a plurality of standoffs or spacers 107-1 and 107-2 may be provided in the exemplary electronic device 100 for maintaining proper spacing between the various elements of the electronic device 100. In one exemplary embodiment, the standoffs or spacers 107-1 and 107-2 are made out of nylon and each having respectively bottom latches 112-1 to 112-2, and 112-3 to 112-4 which are insertable into holes of the corresponding planar regions where the standoffs would sit and are snapped into place.

As shown in Fig. 1A, the exemplary standoff 107-1 sits below and supports the heat spreader planar region 103-2 of the exemplary heat sink assembly 103. Similarly, the exemplary standoff 107-2 sits below and supports the exemplary printed circuit board (PCB) 105. In addition, in one exemplary embodiment, the exemplary PCB 105 of the electronic device 100 is seated on top of a plurality of protrusions 109-1 to 109-4 of another heat spreader metal layer 109. Each of the protrusions 109-1 to 109-4 has a respective thermal putty layer 114-1 to 114-4 in order to provide proper thermal conductivity for the PCB 105 in contact.

Again, Fig. 1C is a perspective view of the exemplary electronic device 100. In particular, Fig. 1C illustrates how the exemplary retaining clip 101 is adapted to be applied to the assemblies of the electronic device 100. According to the present principles, the exemplary clip 101 is to be applied by first inserting the bottom L-shape bend 101-6 into the lower mounting slot 108 of a metal frame 102, and then the retaining clip 101 may be hooked over the assemblies of the exemplary electronic device 100 by clipping the top V-shape bend 101-4 into the upper mounting slot 113 of a heat spreader planar region 103-2.

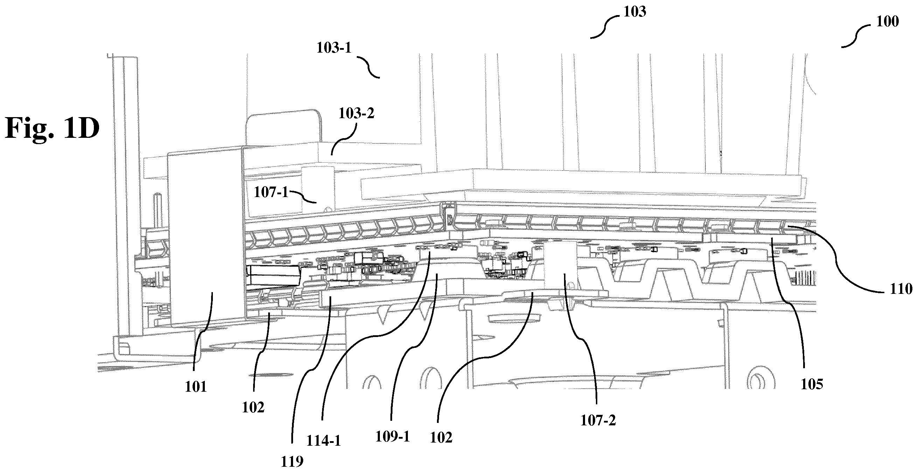

Fig. 1D is a perspective view of the same exemplary electronic device 100 shown in Fig. 1C, but rotated in the upward and right direction. Fig. 2 illustrates the same exemplary electronic device 100 but without the heat sink assembly 103 on top and without the exemplary metal retaining clip 101. As shown in Fig. 2, a plurality of circle-shape thermal putty layers 104-1, and 104-3 to 104-6 may also be applied accordingly so that the heat sink assembly 103 may be seated appropriately on top of these circle-shape thermal putty layers so that desired heat dissipation may be achieved. Fig. 3 illustrates the bottom assembly of the electronic device assemblies according to the present principles. The bottom assembly includes a heat spreader planar region 119 with a plurality of protrusions 109-1 to 109-4 and also a metal frame 102 with the bottom mounting slot 108, as already described before.

While several embodiments have been described and illustrated herein, those of ordinary skill in the art will readily envision a variety of other means and/or structures for performing the functions and/or obtaining the results and/or one or more of the advantages described herein, and each of such variations and/or modifications is deemed to be within the scope of the present embodiments. More generally, those skilled in the art will readily appreciate that all parameters, dimensions, materials, and configurations described herein are meant to be exemplary and that the actual parameters, dimensions, materials, and/or configurations will depend upon the specific application or applications for which the teachings herein is/are used. Those skilled in the art will recognize, or be able to ascertain using no more than routine experimentation, many equivalents to the specific embodiments described herein. It is, therefore, to be understood that the foregoing embodiments are presented by way of example only and that, within the scope of the appended claims and equivalents thereof, the embodiments disclosed may be practiced otherwise than as specifically described and claimed. The present embodiments are directed to each individual feature, system, article, material and/or method described herein. In addition, any combination of two or more such features, systems, articles, materials and/or methods, if such features, systems, articles, materials and/or methods are not mutually inconsistent, is included within the scope of the present embodiment.

## Claims

1. A retaining clip for an electronic device comprising:
a first planar region (101-1) having a first end and a second end;
a second planar region (101-2) on the second end of the first planar region;
a third planar region (101-3) on the first end of the first planar region;
a V-shape bend (101-4) on an end of the third planar region; and
an L-shape bend (101-6) on an end of the second planar region.

2. The retaining clip of claim 1 wherein the V-shape bend comprises a fourth planar region (101-7) which is perpendicular to the third planar region and a fifth planar region which is in an angle to the fourth planar region.

3. The retaining clip of claim 2 wherein the angle is an acute angle.

4. The retaining clip of any one of the preceding claims further comprising an upwardly extending planar region (101-5).

5. The retaining clip of claim 4 wherein the upwardly extending planar region being configured for manipulating the V-shape bend (101-4) into a first mounting slot (113) of a heat spreader planar region (103-2) of a heat sink assembly (103) included in the electronic device.

6. The retaining clip of claim 5 wherein the L-shape bend being configured for being inserted into a second mounting slot (108) of a metal frame (102) of the electronic device.

7. The retaining clip of any one of claims 1-6 wherein the second planar region and the third planar region are parallel to each other and are perpendicular to the first planar region.

8. The retaining clip of any one of the preceding claims wherein the third planar region has a length which is longer than a length of the second planar region.

9. The retaining clip of any of the preceding claims wherein the retaining clip is made from a single piece of material.

10. The retaining clip of claim 8 or 9 wherein the material is elastic to provide a springing action to compress the heat sink assembly.

11. The retaining clip of claim 9 wherein the material is stainless steel.

12. An electronic device comprising at least one retaining clip of any preceding claim.

13. An electronic device according to claim 12 further comprising: a printed circuit board positioned below the heat sink assembly; a component mounted on the printed circuit board; and a metal shield covering the component; wherein the metal frame is positioned below the printed circuit board and has a second mounting slot; wherein the V-shape bend of the retaining clip is inserted into the first mounting slot of the heat spreader planar region of the heat sink assembly; and the L-shape bend is inserted into the second mounting slot.

14. The electronic device according to claim 12 or 13 further comprising a first standoff below the heat spreader planar region of the heat sink assembly.

15. The electronic device according to claim 14 further comprising a second standoff below the printed circuit board.
